# EUROPEAN PATENT APPLICATION

(11) **EP 2 743 967 A1**
(43) Date of publication of application: **18.06.2014**
(21) Application number: 12814632.1
(22) Date of filing: 17.07.2012
(51) Int. Cl.: H01L 21/225, H01L 31/04

(54) **COMPOSITION THAT FORMS N-TYPE DIFFUSION LAYER, N-TYPE DIFFUSION LAYER MANUFACTURING METHOD AND SOLAR CELL ELEMENT MANUFACTURING METHOD**

(30) Priority: 19.07.2011 JP 2011158489
(71) Applicant: Hitachi Chemical Company, Ltd., Chiyoda-ku Tokyo 100-6606 (JP)
(72) Inventor: MACHII, Yoichi, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); IWAMURO, Mitsunori, Tsukuba-shi Ibaraki 300-4247 (JP); ORITA, Akihiro, Tsukuba-shi Ibaraki 300-4247 (JP); ADACHI, Shuichiro, Tsukuba-shi Ibaraki 300-4247 (JP); SATO, Tetsuya, Tsukuba-shi Ibaraki 300-4247 (JP)
(74) Representative: HOFFMANN EITLE
(86) International application number: PCT/JP2012/068122
(87) International publication number: WO 2013/011986

(57) **Abstract**

A composition for forming an n-type diffusion layer includes a glass powder containing P₂O₅, SiO₂ and CaO and a dispersion medium. An n-type diffusion layer and a photovoltaic cell element having an n-type diffusion layer are produced by applying the composition for forming an n-type diffusion layer on a semiconductor substrate and by subjecting the substrate to a thermal diffusion treatment.

## Description

### Technical Field

the present invention relates to a composition for forming an n-type diffusion layer for a photovoltaic cell element, a method of producing an n-type diffusion layer for a photovoltaic cell element, and a method of producing a photovoltaic cell element. More specifically, the present invention relates to a technique that enables the formation of an n-type diffusion layer on a specific portion of a silicon semiconductor substrate.

### Background Art

The production process of a conventional silicon photovoltaic cell element will be described.

In order to obtain a high efficiency by promoting a light confinement effect, a p-type silicon substrate is prepared wherein a texture structure is formed on a light receiving surface of the p-type silicon substrate, and subsequently, the silicon substrate is subjected to a treatment under an atmosphere of a mixed gas of phosphorus oxychloride (POCl₃), which is a donor element-containing compound, nitrogen, and oxygen for several tens of minutes at from 800°C to 900°C to form an n-type diffusion layer uniformly. Since the diffusion of phosphorus is carried out using a mixed gas in the conventional method, an n-type diffusion layer is formed not only on a front surface but also on a side surface and a back surface. For this reason, a side etching process is needed for removing the n-type diffusion layer on the side surface. The n-type diffusion layer on the back surface needs to be converted to a p⁺-type diffusion layer, and the n-type diffusion layer has been converted to a p⁺-type diffusion layer by means of aluminum diffusion by providing an aluminum paste on the n-type diffusion layer of the back surface.

On the other hand, in the field of semiconductor manufacturing, a method in which an n-type diffusion layer is formed by applying a solution containing, as a donor element-containing compound, a phosphoric acid salt such as phosphorus pentaoxide (P₂O₅) or ammonium dihydrogen phosphate (NH₄H₂PO₄), is proposed (see, for example, Japanese Patent Application Laid-Open (JP-A) No. 2002-75894). A technique for forming a diffusion layer in which a paste containing phosphorus as a donor element is applied, as a diffusion source, on a front surface of a silicon substrate and a diffusion layer is formed by thermal diffusion is also known (see, for example, Japanese Patent No. 4073968).

### SUMMARY OF INVENTION

### Technical Problem

However, in the methods above, a donor element or a compound containing a donor element scatters from a solution or paste, which is a diffusion source, and thus, phosphorus diffuses on a side surface and a back surface during the formation of a diffusion layer, similarly to in the above gas phase reaction method in which the mixed gas is used.

As mentioned above, in the case of forming an n-type diffusion layer in a gas phase reaction using phosphorus oxychloride, an n-type diffusion layer is formed not only on one surface (usually a light receiving surface, or a front surface), which originally needs an n-type diffusion layer, but also on the other surface (non-light receiving surface, or a back surface) or on a side surface. Further, in a method in which a solution or paste including a compound containing phosphorus is applied and thermally diffused, an n-type diffusion layer is formed on a surface other than the front surface. For this reason, in order for a photovoltaic cell element to have a pn junction structure, etching is needed on the side surface, and the n-type diffusion layer needs to be converted into a p-type diffusion layer on the back surface. In general, a paste of aluminum, which is an element of Group 13 of the periodic table, is applied on a back surface, and sintering is performed to convert an n-type diffusion layer to a p-type diffusion layer. Further, in a conventionally known method in which a paste containing a donor element such as phosphorus is applied as a diffusion source, it is difficult to form a diffusion layer selectively in a specific region since a donor element-containing compound becomes a vaporized gas, and the gas diffuses towards a region other than a region in which diffusion is needed.

The present invention has been made in view of the above problems of the related art, and aims to provide: a composition for forming an n-type diffusion layer, which can be applied to the production of a photovoltaic cell element using a semiconductor substrate, and which enables the formation of an n-type diffusion layer in a specific region without forming an n-type diffusion layer in a region in which the formation thereof is not needed; a method of producing an n-type diffusion layer; and a method of producing a photovoltaic cell element. Solution to Problem

Means for solving the problems are as follows.
<1> A composition for forming an n-type diffusion layer, the composition comprising: a glass powder comprising P₂O₅, SiO₂ and CaO; and a dispersion medium.
<2> The composition for forming an n-type diffusion layer according to above <1>, wherein the glass powder comprises P₂O₅ in an amount of from 20 mol% to 50 mol%, SiO₂ in an amount of from 30 mol% to 70 mol%, and CaO in an amount of from 2 mol% to 30 mol%.
<3> The composition for forming an n-type diffusion layer according to above <1> or <2>, wherein the glass powder has a volume average particle diameter of 10 µm or less.
<4> The composition for forming an n-type diffusion layer according to any one of above <1> to <3>, wherein the glass powder is present in an amount of from 1% by mass to 30% by mass with respect to a total mass.
<5> The composition for forming an n-type diffusion layer according to any one of above <1> to <4>, having a viscosity of from 1 Pa·s to 500 Pa·s.
<6> The composition for forming an n-type diffusion layer according to any one of above <1> to <5>, wherein the dispersion medium comprises at least one selected from terpineol or butyl carbitol acetate.
<7> The composition for forming an n-type diffusion layer according to any one of above <1> to <6>, wherein the dispersion medium comprises ethyl cellulose.
<8> A method of producing an n-type diffusion layer, the method comprising the processes of:
   applying the composition for forming an n-type diffusion layer according to any one of above <1> to <7> onto a semiconductor substrate; and
   subjecting the semiconductor substrate, on which the composition for forming an n-type diffusion layer has been applied, to a thermal diffusion treatment to form an n-type diffusion layer.
<9> The method of producing an n-type diffusion layer according to above <8>, wherein a temperature of the thermal diffusion treatment is from 800°C to 1000°C.
<10> The method of producing an n-type diffusion layer according to above <8> or 9, further comprising, prior to the thermal diffusion treatment, heat treating the semiconductor substrate, on which the composition for forming an n-type diffusion layer has been applied, at a temperature of from 80°C to 300°C to remove at least a part of the dispersion medium comprised in the composition for forming an n-type diffusion layer.
<11> The method of producing an n-type diffusion layer according to any one of above <8> to <10>, further comprising, prior to the thermal diffusion treatment, heat treating the semiconductor substrate, on which the composition for forming an n-type diffusion layer has been applied, at a temperature from higher than 300°C to 800°C to remove at least a part of the dispersion medium comprised in the composition for forming an n-type diffusion layer.
<12> The method of producing an n-type diffusion layer according to any one of above <8> to <11>, further comprising, after the thermal diffusion treatment, etching a surface of the n-type diffusion layer formed on the semiconductor substrate using hydrofluoric acid.
<13> A method of producing a photovoltaic cell element, the method comprising the processes of:
   applying the composition for forming an n-type diffusion layer according to any one of above <1> to <7> onto a semiconductor substrate;
   subjecting the semiconductor substrate, on which the composition for forming an n-type diffusion layer has been applied, to a thermal diffusion treatment to form an n-type diffusion layer; and
   forming an electrode on the formed n-type diffusion layer.
<14> Use of the composition for forming an n-type diffusion layer according to any one of above <1> to <7> in the production of the n-type diffusion layer.
<15> Use of the composition for forming an n-type diffusion layer according to any one of above <1> to <7> in the production of a photovoltaic cell element comprising a semiconductor substrate, an n-type diffusion layer, and an electrode.

### Advantageous Effects of Invention

According to the invention, a composition for forming an n-type diffusion layer which is applicable to the production of a photovoltaic cell element using a semiconductor substrate, and which enables the formation of an n-type diffusion layer in a specific region without forming an n-type diffusion layer in a region in which the formation thereof is not needed; a method of producing an n-type diffusion layer; and a method of producing a photovoltaic cell element, are provided.

### BRIEF DESCRIPTION OF DRAWINGS

Fig. 1 is a schematic cross-sectional view conceptually showing an example of the method of producing a photovoltaic cell according to the present invention.
Fig. 2A is a plan view of the photovoltaic cell element seen from a front surface.
Fig. 2B is a partially enlarged perspective view of Fig. 2A.

### DESCRIPTION OF EMBODIMENTS

First, a composition for forming an n-type diffusion layer of the invention will be described, and then, a method of producing an n-type diffusion layer using the composition for forming an n-type diffusion layer and a method of producing a photovoltaic cell element will be described.

As used herein, the term "process" includes an independent process as well as a process which cannot be clearly separated from other processes provided the intended actions of such a process is achieved. Further, as used herein, a numerical range expressed by "A to B" refers to a range including A and B as the minimum value and the maximum value, respectively. Furthermore, when a composition has plural substances corresponding to one component, the amount of the component in the composition means the total amount of the plural substances contained in the composition, unless otherwise specified.

A composition for forming an n-type diffusion layer of the invention contains a glass powder (hereafter, also simply referred to as "glass powder") at least including P₂O₅, SiO₂ and CaO, and a dispersion medium, and may further contain other additives as needed in consideration of the application capacity (coating property) of the composition.

Here, a composition for forming an n-type diffusion layer refers to a material which contains a glass powder containing a donor element, and which is capable of forming an n-type diffusion layer by application of the composition onto a semiconductor substrate, followed by thermal diffusion of the donor element. By using a composition for forming an n-type diffusion layer containing a donor element-containing glass powder, an n-type diffusion layer is formed in a desired region, while an unnecessary n-type diffusion layer is not formed on a back surface or a side surface.

Thus, when a composition for forming an n-type diffusion layer of the invention is employed, a side etching process, which is indispensable in the widely adopted gas phase reaction method, is not needed, and the process becomes simple. Also, the process of converting an n-type diffusion layer formed on the back surface into a p⁺-type diffusion layer is not needed. Therefore, the method of forming a p⁺-type diffusion layer on the back surface, and the material, shape and thickness of the back electrode are not limited, and there is a wider choice in the production method, material and shape to be employed. As will be described in detail below, the occurrence of internal stress in the semiconductor substrate due to the thickness of the back electrode is suppressed, and warpage of a semiconductor substrate is also suppressed. Further, it is also possible to form a selective emitter structure in which the concentration of a donor element immediately under the electrode is higher than that of other portions.

A glass powder contained in the composition for forming an n-type diffusion layer of the invention melts by sintering to form a glass layer on the n-type diffusion layer. On the other hand, a glass layer is also formed on an n-type diffusion layer in a conventional gas phase reaction method or a method in which a solution or paste containing phosphate is applied. Therefore, the glass layer formed in the present invention may be removed by etching in a similar manner to that in conventional methods. Accordingly, the composition for forming an n-type diffusion layer of the invention does not generate an unnecessary product and does not increase the number of processes, as compared with conventional methods.

Since a donor element in a glass powder is hard to vaporize even during sintering, the formation of an n-type diffusion layer not only on a front surface but also on a back surface or a side surface due to generation of a vaporized gas is suppressed. This is thought to be because the donor element is hard to vaporize since the donor element is bonded to other elements in the glass powder or incorporated into the glass.

As mentioned above, since it is possible to form an n-type diffusion layer having a desired concentration in a desired region by using the composition for forming an n-type diffusion layer of the invention, it is possible to form a selective region in which the concentration of the n-type donor element (dopant) is high. In contrast, it is generally difficult to form a selective region in which the concentration of the n-type donor element is high by a gas phase reaction method, which is a general method for an n-type diffusion layer, or a method in which a phosphate-containing solution is used.

A glass powder according to the invention will be described in detail.

A glass powder according to the invention includes a donor element. The donor element is an element which is capable of forming an n-type diffusion layer by diffusing (doping) the element in a semiconductor substrate. In the present invention, P (phosphorus) is used for a donor element. As a donor element-containing material used for introducing a donor element in a glass powder, P₂O₅ is used.

The glass powder at least includes SiO₂ and CaO as glass component materials.

A glass powder according to the invention has low moisture-absorption characteristics and an excellent preservation stability since it contains a combination of P₂O₅ which is a donor element-containing material and SiO₂ and CaO which are glass component materials. Therefore, since, even after a long-term preservation, a donor component in a glass powder is hard to vaporize during sintering, the formation of an n-type diffusion layer not only on a front surface but on a back surface or a side surface due to generation of a vaporized gas is suppressed.

It is desirable that the content ratio of the donor element-containing material and the glass component material in the glass powder is appropriately set in consideration of the melting temperature, the softening temperature, the glass transition temperature, the chemical durability, the etching characteristics, or the like. Specifically, in terms of the water resistance, the melting temperature, and the diffusing capacity, the mole fraction of P₂O₅ contained in the glass powder is preferably from 20 mol% to 50 mol%, and more preferably from 25 mol% to 45 mol%. In terms of the water resistance, the melting temperature, and the etching characteristics, the mole fraction of SiO₂ is preferably from 30 mol% to 70 mol%, and more preferably from 35 mol% to 65 mol%. In terms of the water resistance, the melting temperature, the etching characteristics, and the mole fraction of CaO is preferably from 2 mol% to 30 mol%, and more preferably from 5 mol% to 25 mol%.

Although the total mole fraction of P₂O₅, SiO₂, and CaO in the glass powder may be 100%, the glass powder may further include the following glass component materials other than P₂O₅ and SiO₂, and CaO. Examples of the glass component material which can be added thereto include K₂O, Na₂O, Li₂O, BaO, SrO, MgO, BeO, ZnO, PbO, CdO, V₂O₅, SnO, ZrO₂, MoO₃, La₂O₃, Nb₂O₅, Ta₂O₅, Y₂O₃, TiO₂, ZrO₂, GeO₂, Al₂O₃, TeO₂ and Lu₂O₃. The melting temperature, the softening temperature, the glass transition temperature, the chemical durability, or the like of the other glass component materials other than SiO₂ and CaO may be controlled by adjusting the component ratios thereof as needed. When the glass powder includes a glass component material other than SiO₂ and CaO, in terms of the water resistance, the melting temperature, the etching characteristics, and the diffusing capacity, the mole fraction of the glass component material other than SiO₂ and CaO in the glass powder may be from 0.01 mol% to 10 mol%, and more preferably from 0.1 mol% to 5 mol%.

In terms of the diffusing properties during a diffusion treatment and the liquid dripping, the softening temperature of the glass powder is preferably from 300°C to 1000°C, and more preferably from 400°C to 900°C. When the softening temperature is 300°C or higher, the viscosity of the glass does not become too low during the diffusion treatment, and occurrence of liquid dripping is suppressed, whereby the formation of an n-type diffusion layer on a portion other than a specific portion tends to be suppressed. When the softening temperature is 1000°C or lower, a phenomenon in which the glass powder does not melt sufficiently, and a uniform n-type diffusion layer is thus not formed, tends to be readily suppressed.

Since, as mentioned above, the occurrence of liquid dripping is readily suppressed by setting the softening temperature of the glass powder in a range of from 300°C to 1000°C, an n-type diffusion layer tends to be readily formed on a specific region in a desired shape after a diffusion treatment. For example, when the composition for forming an n-type diffusion layer is applied in a linear pattern having a width of "a" µm, a linear pattern having a line width "b" in a range of b < 1.5a µm is retained after the diffusion treatment.

The softening temperature of the glass powder may be determined from a differential thermal analysis (DTA) curve or the like obtained using DTG-60H Simultaneous Thermogravimetry/Differential Thermal Analyzer (available from Shimadzu Scientific Instruments).

The shape of the glass powder may be a substantially spherical shape, a flat shape, a block shape, a plate shape, a scale-like shape, or the like. In terms of the application capacity (coating property) onto a substrate and uniform dispersion property of the composition for forming an n-type diffusion layer containing the glass powder, it is preferable that the glass powder has a substantially spherical shape, a flat shape, or a plate shape.

The glass powder preferably has a volume average particle diameter of 10 µm or less. When a glass powder having a volume average particle diameter of 10 µm or less is used, a smooth coated film may be readily obtained. Further, the volume average particle diameter of the glass powder is more preferably 5 µm or less, further more preferably 2 µm or less, and particularly preferably 1 µm or less. The lower limit of the volume average particle diameter of the glass powder is not particularly limited, and preferably 0.01 µm or larger, and more preferably 0.05 µm or larger.

The volume average particle diameter of the glass powder may be measured by a laser diffraction particle size analyzer or the like.

A glass powder including P₂O₅, SiO₂ and CaO is prepared by the following procedure.

First, raw materials are weighed and placed in a crucible. Examples of the material for the crucible include platinum, platinum-rhodium, gold, iridium, alumina, zirconia, quartz, carbon, boron carbide, boron nitride, and silicon nitride. The material of the crucible is appropriately selected taking into consideration the melting temperature, atmosphere, reactivity with melted materials, and the like.

Next, the raw materials are heated in an electric furnace to a temperature depending on the glass formulation, thereby preparing a melt solution. At this time, stirring is preferably applied such that the melt solution becomes homogenous.

Subsequently, the obtained melt solution is allowed to flow on a zirconia substrate, a carbon substrate or the like to result in vitrification of the melt solution.

Finally, the glass is pulverized into a powder. The pulverization may be carried out by a known method such as using a stamp mill, a jet mill, bead mill or ball mill.

The content ratio of the glass powder in the composition for forming an n-type diffusion layer is determined taking into consideration the application capacity, diffusing properties of donor elements, and the like. In general, the content ratio of the glass powder in the composition for forming an n-type diffusion layer is preferably from 1% by mass to 30% by mass, more preferably from 5% by mass to 25% by mass, and further more preferably from 8% by mass to 20% by mass.

In the invention, in terms of the water resistance, the melting temperature, the etching characteristic, and the diffusing capacity, the glass powder may include P₂O₅ in a mole fraction of from 20 mol% to 50 mol%, SiO₂ in a mole fraction of from 30% to 70%, and CaO in a mole fraction of from 5 mol% to 25 mol%, and have a volume average particle diameter of from 0.01 µm to 2 µm; or alternatively, the glass powder may include P₂O₅ in a mole fraction of from 20 mol% to 50 mol%, SiO₂ in a mole fraction of from 35% to 65%, and CaO in a mole fraction of from 2 mol% to 30 mol%, and have a volume average particle diameter of from 0.01 µm to 2 µm. In terms of the water resistance, the melting temperature, the etching characteristic, and the diffusing capacity, the glass powder may include P₂O₅ in a mole fraction of from 25 mol% to 45 mol%, SiO₂ in a mole fraction of from 30% to 70%, and CaO in a mole fraction of from 2 mol% to 30 mol%, and have a volume average particle diameter of from 0.01 µm to 2 µm.

In the invention, in terms of the water resistance, the melting temperature, the etching characteristic, and the diffusing capacity, it is more preferable that the glass powder include P₂O₅ in a mole fraction of from 25 mol% to 45 mol%, SiO₂ in a mole fraction of from 35% to 65%, and CaO in a mole fraction of from 5 mol% to 25 mol%, and have a volume average particle diameter of from 0.01 µm to 2 µm.

Hereinafter, a dispersion medium will be described.

The dispersion medium is a medium which disperses the glass powder in the composition. Specifically, at least one selected from the group consisting of a binder and a solvent is employed as the dispersion medium.

Examples of the binder which may be appropriately selected include a polyvinyl alcohol, polyacrylamide resins, polyvinyl amide resins, polyvinyl pyrrolidone, polyethylene oxide resins, polysulfonic acid, acrylamide alkylsulfonic acid, cellulose ether resins, cellulose derivatives, carboxymethylcellulose, hydroxyethylcellulose, ethyl cellulose, gelatin, starch and starch derivatives, sodium alginates and sodium alginate derivatives, xanthane and xanthane derivatives, guar gum and guar gum derivatives, scleroglucan and scleroglucan derivatives, tragacanth and tragacanth derivatives, dextrin and dextrin derivatives, (meth)acrylic acid resins, (meth)acrylic acid ester resins (for example, alkyl(meth)acrylate resins, dimethylaminoethyl (meth)acrylate resins, or the like), butadiene resins, styrene resins, and copolymers thereof. Other than these, siloxane resins or the like may be appropriately selected. These binders may be used singly or in a combination of two or more thereof. Among these, ethyl cellulose is suitable as the binder in terms of viscosity property.

The molecular weight of the binder is not particularly restricted, and desirably is appropriately adjusted in view of a desired viscosity of the composition. For example, the content ratio of the binder in the composition may be an amount by which the following viscosity is attained.

In view of the application property during printing, the viscosity of the composition for forming an n-type diffusion layer is preferably in a range of from 1 Pa·s to 500 Pa·s, and more preferably in a range of from 10 Pa·s to 100 Pa·s.

The measurement of the viscosity is carried out using E-TYPE VISCOMETER TYPE-EHD (manufactured by TOKYO KEIKI, Inc.) under conditions that the amount of a sample is 0.4 ml and the number of revolutions is 5 rpm.

Examples of the solvent include ketone solvents such as acetone, methyl ethyl ketone, methyl-n-propylketone, methyl-i-propylketone, methyl-n-butylketone, methyl-i-butylketone, methyl-n-pentylketone, methyl-n-hexylketone, diethylketone, dipropylketone, di-i-butylketone, trimethylnonanone, cyclohexanone, cyclopentanone, methylcyclohexanone, 2,4-pentanedione, or acetonylacetone; ether solvents such as diethyl ether, methyl ethyl ether, methyl-n-propyl ether, di-i-propyl ether, tetrahydrofuran, methyl tetrahydrofuran, dioxane, dimethyl dioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl-n-propyl ether, diethylene glycol methyl-n-butyl ether, diethylene glycol di-n-propyl ether, diethylene glycol di-n-butyl ether, diethylene glycol methyl-n-hexyl ether, triethylene glycol dimethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetraethylene glycol diethyl ether, tetradiethylene glycol methyl ethyl ether, tetraethylene glycol methyl-n-butyl ether, diethylene glycol di-n-butyl ether, tetraethylene glycol methyl-n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl-n-butyl ether, dipropylene glycol di-n-propyl ether, dipropylene glycol di-n-butyl ether, dipropylene glycol methyl-n-hexyl ether, tripropylene glycol dimethyl ether, tripropylene glycol diethyl ether, tripropylene glycol methyl ethyl ether, tripropylene glycol methyl-n-butyl ether, tripropylene glycol di-n-butyl ether, tripropylene glycol methyl-n-hexyl ether, tetrapropylene glycol dimethyl ether, tetrapropylene glycol diethyl ether, tetradipropylene glycol methyl ethyl ether, tetrapropylene glycol methyl-n-butyl ether, dipropylene glycol di-n-butyl ether, tetrapropylene glycol methyl-n-hexyl ether, or tetrapropylene glycol di-n-butyl ether; ester solvents such as methyl acetate, ethyl acetate, n-propyl acetate, i-propyl acetate, n-butyl acetate, i-butyl acetate, s-butyl acetate, n-pentyl acetate, s-pentyl acetate, 3-methoxybutyl acetate, methyl pentyl acetate, 2-ethyl butyl acetate, 2-ethyl hexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, diethylene glycol methyl ether acetate, diethylene glycol monoethyl ether acetate, diethylene glycol monobutyl ether acetate, dipropylene glycol methyl ether acetate, dipropylene glycol ethyl ether acetate, glycol diacetate, methoxy triglycol acetate, ethyl propionate, n-butyl propionate, i-amyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, γ-butyrolactone, or γ-valerolactone; aprotic polar solvents such as acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetamide, or N,N-dimethyl sulfoxide; alcohol solvents such as methanol, ethanol, n-propanol, i-propanol, n-butanol, i-butanol, s-butanol, t-butanol, n-pentanol, i-pentanol, 2-methylbutanol, s-pentanol, t-pentanol, 3-methoxy butanol, n-hexanol, 2-methylpentanol, s-hexanol, 2-ethylbutanol, sec-heptanol, n-octanol, 2-ethylhexanol, s-octanol, n-nonyl alcohol, n-decanol, s-undecyl alcohol, trimethylnonyl alcohol, s-tetradecyl alcohol, s-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, or tripropylene glycol; glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, or tripropylene glycol monomethyl ether; terpene solvents such as α-terpinene, terpinenol, myrcene, allo-ocimene, imonene, dipentene, α-pinene, β-pinene, terpinenol, carvone, ocimene or phellandrene; and water. These solvents may be used singly or in a combination of two or more thereof.

In the composition for forming an n-type diffusion layer, in terms of the application capacity onto a substrate, the solvent is preferably at least one selected from terpineol or butyl carbitol acetate (diethylene glycol mono-n-butyl ether acetic acid). The content ratio of dispersion medium in the composition for forming an n-type diffusion layer is determined in consideration of the application capacity and the donor concentration.

Next, a method of producing an n-type diffusion layer and method of producing a photovoltaic cell element of the invention will be described.

The method of producing an n-type diffusion layer of the invention includes processes of: applying the above-mentioned composition for forming an n-type diffusion layer onto a semiconductor substrate; and subjecting the semiconductor substrate, on which the composition for forming an n-type diffusion layer has been applied, to a thermal diffusion treatment to form an n-type diffusion layer.

The method of producing a photovoltaic cell element of the invention includes processes of: applying the above-mentioned composition for forming an n-type diffusion layer onto a semiconductor substrate; subjecting the semiconductor substrate, on which the composition for forming an n-type diffusion layer has been applied, to a thermal diffusion treatment to form an n-type diffusion layer; and forming an electrode on the formed n-type diffusion layer.

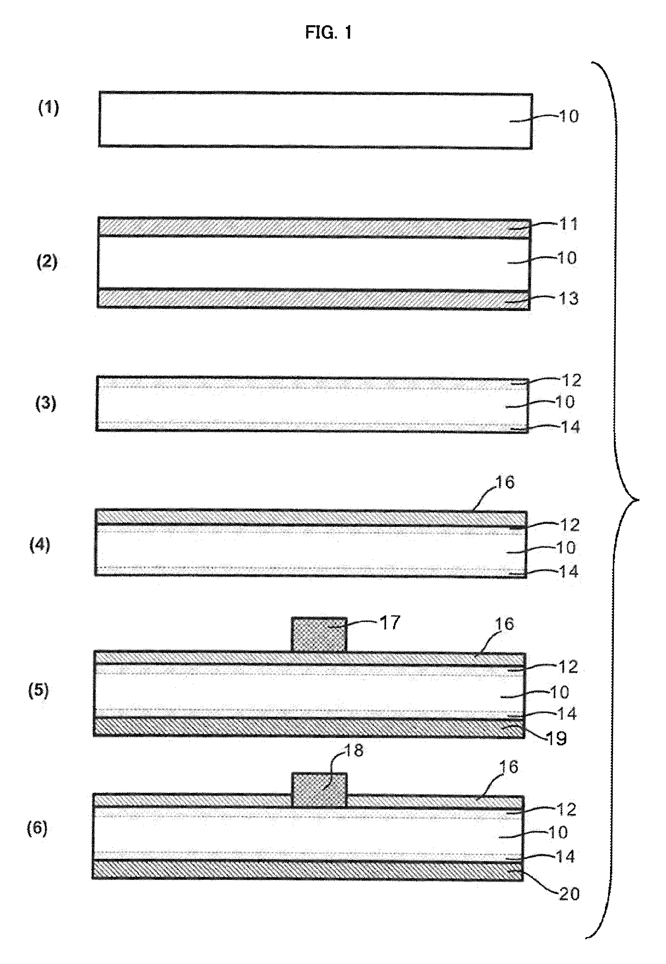

Hereinafter, a description will be made with reference to Fig. 1. Fig. 1 is a schematic cross-sectional view conceptually showing an example of the production processes of a photovoltaic cell of the present invention. In Fig. 1, numerical symbol 10 indicates a p-type semiconductor substrate; numerical symbol 12 indicates an n-type diffusion layer; numerical symbol 14 indicates a p⁺-type diffusion layer; numerical symbol 16 indicates an anti-reflection film; numerical symbol 18 indicates a surface electrode; and numerical symbol 20 indicates a back electrode (electrode layer), respectively. In the following drawings, like numerals refer to like components, and the description thereof is omitted. In the following, an example in which a silicon substrate is used as a p-type semiconductor substrate will be described, but a semiconductor substrate in the invention in not limited to a silicon substrate.

In Fig. 1(1), an alkaline solution is applied onto a silicon substrate which is a p-type semiconductor substrate 10 to remove a damaged layer, and a texture structure is obtained by etching.

Specifically, the damaged layer of the silicon surface, which is caused when being sliced from an ingot, is removed using 20%-by-mass caustic soda. Then, a texture structure is formed by etching with a mixture of 1% by mass of caustic soda and 10% by mass of isopropyl alcohol (in the drawing, the texture structure is omitted). Through the formation of a texture structure on the light-receiving side (front surface) of the silicon substrate, light confinement effect is promoted, and high efficiency of the photovoltaic cell element is achieved.

In Fig. 1(2), the composition for forming an n-type diffusion layer is applied on a front surface (that is, a surface to be a light-receiving surface) of the p-type semiconductor substrate 10, thereby forming an n-type diffusion layer-forming composition layer 11. In the invention, the application method is not particularly restricted, and examples thereof include a printing method, a spin-coat method, brush application, a spray method, a doctor blade method, a roll coater method, and an inkjet method. Among these, a printing method, in particular, a screen printing method is suitable.

The amount of the composition for forming an n-type diffusion layer to be applied is not particularly restricted, and for example, may be an amount such that the amount of glass powder is from 0.01g/m² to 100g/m², and preferably from 0.1g/m² to 10g/m².

Depending on the formulation of the composition for forming an n-type diffusion layer, prior to a thermal diffusion treatment, a process of heat treating a substrate, on which the composition for forming an n-type diffusion layer has been applied, may be needed in order to remove at least a part of the solvent contained in the composition. In this case, the heat treatment may be carried out under conditions such as a temperature of from 80°C to 300°C, and for about 1 minute to 10 minutes when a hot plate is used, or for about 10 minutes to 30 minutes when a dryer or the like is used. The heat treatment conditions depend on the solvent formulation of the composition for forming an n-type diffusion layer, but the invention is not limited thereto. By the heat treatment process, the composition for forming an n-type diffusion layer applied on the substrate is dried.

Depending on the formulation of the composition for forming an n-type diffusion layer, prior to a thermal diffusion treatment, a process of heat treating a substrate, on which the composition for forming an n-type diffusion layer has been applied, may be needed in order to volatilize and remove at least a part of the dispersion medium, in particular, a binder (resin component) contained in the composition. In this case, the heat treatment may be carried out under conditions of a temperature of higher than 300°C and 800°C or less for 1 minute to 10 minutes. For the heat treatment, a known continuous furnace, batch furnace, or the like may be applied.

When the heat treatment is performed, depending on the formulation of the composition for forming an n-type diffusion layer, both of a heat treatment at the above-mentioned temperature of from 80°C to 300°C and a heat treatment at a temperature of higher than 300°C and 800°C or less may be performed (in other words, two heat treatments are performed under different temperature conditions), or only one heat treatment under either temperature may be performed.

When the production method of the invention is used, the method of producing a p⁺-type diffusion layer (high concentration electric field layer) 14 on the back surface is not limited to a method of converting an n-type diffusion layer into a p-type diffusion layer using aluminum, and any conventionally known method may be employed, leading to increase in choices of the production methods. Accordingly, for example, a composition containing an element of Group 13 of the periodic table such as B (boron) may be applied to form a composition layer 13, thereby forming a p⁺-type diffusion layer 14.

Examples of the composition containing an element of Group 13 of the periodic table such as B (boron) include a p-type diffusion layer-forming composition which is produced in a similar manner to the composition for forming an n-type diffusion layer, except that a glass powder containing an acceptor element is used in place of the glass powder containing a donor element. The acceptor element may be any element as long as it is an element of Group 13 of the periodic table, and examples thereof include B (boron), Al (aluminum) and Ga (gallium). The glass powder containing an acceptor element preferably includes at least one selected from the group consisting of B₂O₃, Al₂O₃, and Ga₂O₃.

The method of applying the p-type diffusion layer-forming composition on the back surface of a silicon substrate is similar to the above-mentioned method of applying the composition for forming an n-type diffusion layer on a silicon substrate.

By subjecting the p-type diffusion layer-forming composition applied on the back surface to a thermal diffusion treatment similarly to the thermal diffusion treatment described below of the composition for forming an n-type diffusion layer, a p⁺-type diffusion layer 14 may be formed on the back surface. The thermal diffusion treatment of the p-type diffusion layer-forming composition is preferably performed simultaneously with a thermal diffusion treatment of the composition for forming an n-type diffusion layer.

Subsequently, the p-type semiconductor substrate 10, on which the n-type diffusion layer-forming composition layer 11 has been formed, is subjected to a thermal diffusion treatment. The treatment temperature is preferably from 800°C to 1000°C, and more preferably from 850°C to 980°C. The treatment time is preferably from 5 minutes to 60 minutes. By the thermal diffusion treatment, a donor element is diffused into a semiconductor substrate as illustrated in Fig. 1(3) to form an n-type diffusion layer 12. For the thermal diffusion treatment, a known continuous furnace, batch furnace, or the like may be applied. When performing the thermal diffusion treatment, the furnace atmosphere may be appropriately adjusted with air, oxygen, nitrogen, or the like.

Since a glass layer (not shown) made of phosphate glass or the like is formed on the surface of the formed n-type diffusion layer 12, the phosphate glass is removed by etching. The etching may be carried out by a known method, including a method of dipping a subject in an acid, such as hydrofluoric acid, a method of dipping a subject in an alkali, such as caustic soda, or the like. In terms of etching capability, an etching treatment with hydrofluoric acid is preferred. When a method of dipping a subject in a hydrofluoric acid is used, the time of dipping is not particularly limited, and generally is from 0.5 minutes to 30 minutes, and preferably from 1 minute to 10 minutes.

As shown in Fig. 1(2) and 1(3), in the n-type diffusion layer-forming method of the invention, an n-type diffusion layer 12 is formed in a desired region, while no unnecessary n-type diffusion layer is formed neither on a back surface nor on a side surface.

Accordingly, a side etching process for the removal of an unnecessary n-type diffusion layer formed on the side surface is essential for a method of forming an n-type diffusion layer by the conventionally widely used gas-phase reaction method, while the side etching process is unnecessary, and the process is simplified in the production method of the present invention,. Thus, by the production method of the invention, a uniform n-type diffusion layer having a desired shape is formed in a desired region in a short time.

Further, the conventional production method needs the conversion of an unnecessary n-type diffusion layer formed on the back surface into a p-type diffusion layer, and the conversion method employs a method involving coating the n-type diffusion layer of the back surface with a paste of aluminum, which is an element of Group 13 of the periodic table, followed by sintering to diffuse aluminum into the n-type diffusion layer and convert the n-type diffusion layer into a p-type diffusion layer. Since an amount of aluminum higher than a certain level is required to achieve sufficient conversion into a p-type diffusion layer and to form a high concentration electric field layer of the p-type diffusion layer in this method, it is needed to form a thick aluminum layer. However, since the coefficient of the thermal expansion of aluminum is considerably different from the coefficient of the thermal expansion of the silicon which is used as a substrate, such a difference results in generation of heavy internal stress in the silicon substrate during the sintering and cooling processes, which contributes to warpage of the silicon substrate.

Such internal stress damages the grain boundary of crystals, resulting in the problem of an increase in power loss. Warpage readily leads to damage of a photovoltaic cell element in the conveyance of the photovoltaic cell element or in the connection with a copper wiring referred to as a tab wiring (wiring member), during a module process. In recent years, advancement in slice processing techniques has led to the reduction in thickness of a silicon substrate, which results in a tendency for the photovoltaic cell element to be more readily cracked.

In contrast, since, by the production method of the invention, no unnecessary n-type diffusion layer is formed on the back surface, there is no need for the conversion of an n-type diffusion layer into a p-type diffusion layer, which consequently abolishes the necessity of making the aluminum layer thicker. As a result, it is possible to suppress the generation of internal stress in the silicon substrate or warpage. Accordingly, it is possible to suppress an increase in power loss, or damage to a photovoltaic cell element.

Further, in the production method of the invention, the method of producing a p⁺-type diffusion layer (high concentration electric field layer) 14 on the back surface may employ any method without being limited to the method involving conversion of an n-type diffusion layer into a p-type diffusion layer using aluminum, thereby increasing choices for the production method.

For example, it is preferable to apply the p-type diffusion layer forming composition which is configured similarly to a composition for forming an n-type diffusion layer except that a glass powder containing an acceptor element is used in place of the glass powder containing a donor element on a back surface of a silicon substrate (the opposite surface to the surface to which the n-type diffusion layer forming composition is provided), followed by a thermal diffusion treatment, whereby the p⁺-type diffusion layer (high concentration electric field layer) 14 is formed on the back surface.

As will be described later, the material used for a back electrode 20 is not limited to aluminum of Group 13 of the periodic table. For example, Ag (silver), Cu (copper) or the like may also be used, and the thickness of the surface electrode 20 of the back surface may be further reduced as compared to the conventional one.

In Fig. 1(4), an anti-reflection film 16 is formed over the n-type diffusion layer 12. The anti-reflection film 16 is formed by a known technique. For example, when the anti-reflection film 16 is a silicon nitride film, the anti-reflection film 16 is formed by a plasma CVD method using a mixed gas of SiH₄ and NH₃ as a raw material. At this time, hydrogen diffuses into crystals, and an orbit which does not contribute to bonding of silicon atoms, that is, a dangling bond binds to hydrogen, which inactivates a defect (hydrogen passivation).

More specifically, the anti-reflection film 16 is formed under the conditions of a mixed gas flow ratio (NH₃/SiH₄) of from 0.05 to 1.0, a reaction chamber pressure of from 13.3 Pa (0.1 Torr) to 266.6 Pa (2 Torr), a film-forming temperature of from 300°C to 550°C, and a plasma discharge frequency of 100 kHz or higher.

In Fig. 1(5), a metal paste for a surface electrode is printed and applied on the anti-reflection film 16 of the front surface (light-receiving side) by a screen printing method, followed by drying, thereby forming a metal paste layer 17 for a surface electrode. The metal paste for a surface electrode contains (1) a metal particle and (2) a glass particle as essential components, and optionally (3) a resin binder, (4) other additives, or the like.

Then, a metal paste layer 19 for a back electrode is also formed on the p⁺-type diffusion layer 14 of the back surface. As mentioned above, the constituent material and forming method of the metal paste layer 19 for a back electrode are not particularly limited in the present invention. For example, the metal paste layer 19 for a back electrode may also be formed by applying a back surface electrode paste containing a metal such as aluminum, silver or copper, followed by drying. In this case, a portion of the back surface may also be provided with a silver paste for forming a silver electrode, for connection between photovoltaic cell elements in the module process.

In Fig. 1(6), metal paste layer 17 for an electrode is sintered to complete a photovoltaic cell element. When the sintering is carried out at a temperature in the range of from 600°C to 900°C for several seconds to several minutes, the front surface side undergoes melting of the anti-reflection film 16 which is an insulating film, owing to the glass particles contained in the electrode-forming metal paste, and the surface of the p-type semiconductor substrate 10 is also partially melted, by which metal particles (for example, silver particles) in the paste form a contact with the p-type semiconductor substrate 10, followed by solidification. In this manner, electrical conduction is made between the formed surface electrode 18 and the p-type semiconductor substrate 10. This process is called fire-through. Also on the back surface side, the metal paste for a back electrode of the metal paste layer 19 for a back electrode is sintered to form a back electrode 20.

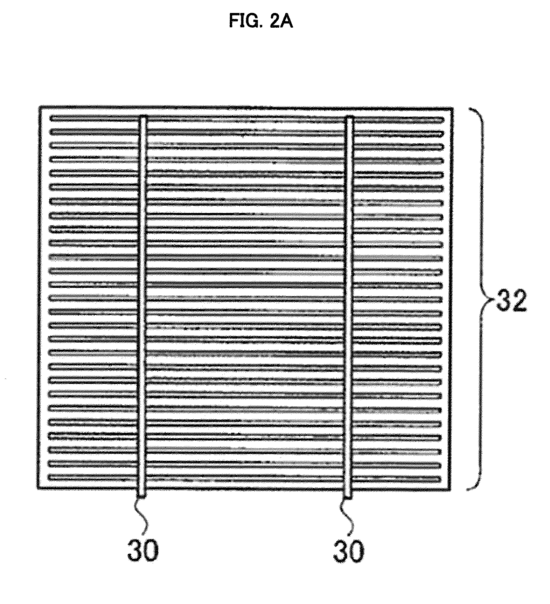

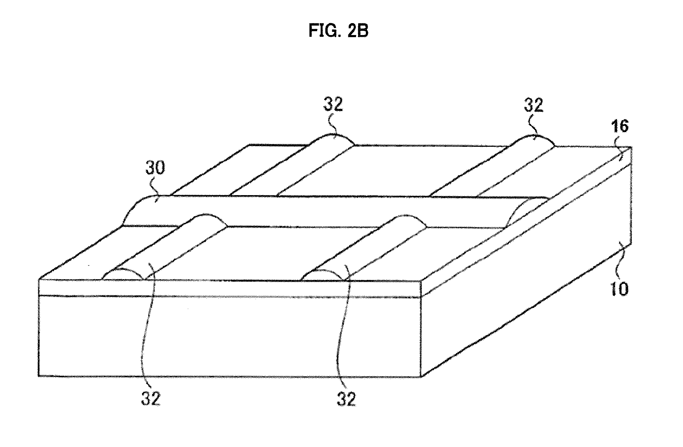

Hereinafter, the shape of the surface electrode 18 is described by referring to Fig 2. In Fig. 2, numerical symbol 30 indicates a bus bar electrode and numerical symbol 32 indicates a finger electrode. The surface electrode 18 is constituted by a bus bar electrode 30 and a finger electrode 32 intersecting the bus bar electrode 30. Fig. 2A is a plan view of a photovoltaic cell element, as seen from the front surface thereof, provided with the surface electrode 18 which is constituted by the bus bar electrodes 30 and the finger electrodes 32 intersecting the bus bar electrodes 30, and Fig. 2B is a partially enlarged perspective view of Fig. 2A.

The surface electrode 18 may be formed, for example, by the above-mentioned screen printing of a metal paste, or plating of an electrode material, deposition of an electrode material by electron beam heating under high vacuum, or the like. It is well known that the surface electrode 18 formed from the bus bar electrode 30 and the finger electrode 32 is typically used as an electrode for the light-receiving surface side, and a known method for the formation of the bus bar electrode and the finger electrode of the light-receiving surface side may be applied.

Although a photovoltaic cell having an n-type diffusion layer formed on the front surface, a p⁺-type diffusion layer formed on the back surface, and a front surface electrode and a back electrode disposed on the respective layers is described above, the use of the composition for forming an n-type diffusion layer enables the production of a back contact photovoltaic cell element.

The back contact photovoltaic cell element is a photovoltaic cell element in which all electrodes are arranged on the back surface to make the area of the light receiving surface large. In other words, the back contact photovoltaic cell element needs to have a pn junction structure by forming both of an n-type diffusion region and a p⁺-type diffusion region on the back surface. The composition for forming an n-type diffusion layer of the invention is capable of forming an n-type diffusion region on a specific region, and thus is suitably applied to the production of a back contact photovoltaic cell element.

The present invention also includes use of the composition for forming an n-type diffusion layer in the production of an n-type diffusion layer, and use of the composition for forming an n-type diffusion layer in the production of a photovoltaic cell element including a semiconductor substrate, n-type diffusion layer, and electrode. As mentioned above, by using the composition for forming an n-type diffusion layer according to the invention, it is possible to obtain a uniform n-type diffusion layer in a specific region in a desired shape in a short time without forming an unnecessary n-type diffusion layer. In addition, a photovoltaic cell element having such an n-type diffusion layer is obtained without forming an unnecessary n-type diffusion layer.

### EXAMPLES

Hereinbelow, examples of the invention will be described in more detail, but the invention is not limited to these Examples. Unless otherwise specified, for all chemicals, reagents are used. Further, "%" means "% by mass" unless otherwise noted.

### [Example 1]

Ten grams of P₂O₅-SiO₂-CaO glass (P₂O₅: 30 mol%, SiO₂: 60 mol%, CaO: 10 mol%) powder whose particle shape was a block shape and which had a volume average particle diameter of 0.89 µm, 5 g of ethyl cellulose, and 85 g of terpineol were mixed using an automatic mortar kneading machine to obtain a paste, thereby preparing a composition for forming an n-type diffusion layer. The viscosity of the obtained composition for forming an n-type diffusion layer was 61 Pa·s.

The particle shape of the glass was observed and judged using a scanning electron microscope TYPE TM-1000 (manufactured by Hitachi High-Technologies Corporation). The average particle diameter of the glass was calculated using LS 13 320 LASER DIFFRACTION PARTICLE SIZE ANALYZER (measurement wavelength: 632 nm; manufactured by Beckman Coulter, Inc.).

The viscosity of the composition for forming an n-type diffusion layer was measured using an E-type viscometer TYPE-EHD (manufactured by TOKYO KEIKI Inc.) under conditions that the amount of a sample was 0.4 ml and the number of revolutions was rpm.

The softening temperature of the glass was determined from a differential thermal analysis (DTA) curve or the like obtained using DTG-60H SIMULTANEOUS THERMOGRAVIMETRY/DIFFERENTIAL THERMAL ANALYZER (manufactured by Shimadzu Scientific Instruments), and the temperature was estimated to be about 800°C.

Next, on a surface of a p-type silicon substrate, the prepared paste was applied by screen printing, and dried at 150°C for 5 minutes on a hot plate, thereby forming a layer. Subsequently, the layer was subjected to a heat treatment in an electric furnace whose temperature was set to 500°C for 5 minutes, and then subjected to a thermal diffusion treatment in another electric furnace for diffusion whose temperature was set to 950°C for 10 minutes. After that, in order to remove a glass layer, the substrate was dipped in hydrofluoric acid for 5 minutes, followed by cleaning with flowing water and drying.

The sheet resistance of the surface on the side on which the composition for forming an n-type diffusion layer was applied was 45 Ω/□. On the surface of the n-type diffusion layer, P (phosphorus) was diffused and an n-type diffusion layer was formed. The sheet resistance of the back surface exceeded the measurement upper limit and was thus not able to be measured, and no n-type diffusion layer was formed.

The sheet resistance was measured by a four-probe method at 25° using a low resistivity meter LORESTA-EP MCP-T360 (manufactured by Mitsubishi Chemical Corporation).

### [Example 2]

Ten grams of P₂O₅-SiO₂-CaO glass (P₂O₅: 30 mol%, SiO₂: 50 mol%, CaO: 20 mol%) powder whose particle shape was a block shape and which had a volume average particle diameter of 0.95 µm, 5 g of ethyl cellulose, and 85 g of butyl carbitol acetate were mixed using an automatic mortar kneading machine to obtain a paste, thereby preparing a composition for forming an n-type diffusion layer. The viscosity of the obtained composition for forming an n-type diffusion layer was 67 Pa·s.

Next, on a surface of a p-type silicon substrate, the prepared paste was applied by screen printing, and dried at 150°C for 5 minutes on a hot plate, thereby forming a layer. Subsequently, the layer was subjected to a heat treatment in an electric furnace whose temperature was set to 500°C for 5 minutes, and then subjected to a thermal diffusion treatment in another electric furnace for diffusion whose temperature was set to 950°C for 10 minutes. After that, in order to remove a glass layer, the substrate was dipped in hydrofluoric acid for 5 minutes, followed by cleaning with flowing water and drying.

The sheet resistance of the surface on the side on which the composition for forming an n-type diffusion layer was applied was 38 Ω/□. On the surface of the n-type diffusion layer, P (phosphorus) was diffused and an n-type diffusion layer was formed. The sheet resistance of the back surface exceeded the measurement upper limit and was thus not able to be measured, and no n-type diffusion layer was formed.

### [Example 3]

Ten grams of P₂O₅-SiO₂-CaO glass (P₂O₅: 40 mol%, SiO₂: 40 mol%, CaO: 20 mol%) powder whose particle shape was a substantially spherical shape and which had a volume average particle diameter of 1.02 µm, 5 g of ethyl cellulose, and 85 g of butyl carbitol acetate were mixed using an automatic mortar kneading machine to obtain a paste, thereby preparing a composition for forming an n-type diffusion layer. The viscosity of the obtained composition for forming an n-type diffusion layer was 65 Pa·s.

Next, on a surface of a p-type silicon substrate, the prepared paste was applied by screen printing, and dried at 150°C for 5 minutes on a hot plate, thereby forming a layer. Subsequently, the layer was subjected to a heat treatment in an electric furnace whose temperature was set to 500°C for 5 minutes, and then subjected to a thermal diffusion treatment in another electric furnace for diffusion whose temperature was set to 950°C for 10 minutes. After that, in order to remove a glass layer, the substrate was dipped in hydrofluoric acid for five minutes, followed by cleaning with flowing water and drying.

The sheet resistance of the surface on the side on which the composition for forming an n-type diffusion layer was applied was 35 Ω/□. On the surface of the n-type diffusion layer, P (phosphorus) was diffused and an n-type diffusion layer was formed. The sheet resistance of the back surface exceeded the measurement upper limit and was not able to be measured, and no n-type diffusion layer was formed.

### [Comparative Example 1]

Ten grams of ammonium dihydrogen phosphate (NH₄H₂PO₄) powder, 5 g of ethyl cellulose, and 85 g of terpineol were mixed using an automatic mortar kneading machine to obtain a paste, thereby preparing a composition for an n-type diffusion layer.

Next, on a surface of a p-type silicon substrate, the prepared paste was applied by screen printing, and dried at 150°C for 5 minutes on a hot plate, thereby forming a layer. Subsequently, the layer was subjected to a heat treatment in an electric furnace whose temperature was set to 500°C for 5 minutes, and then subjected to a thermal diffusion treatment in another electric furnace for diffusion whose temperature was set to 950°C for 10 minutes. After that, in order to remove a glass layer, the substrate was dipped in hydrofluoric acid for 5 minutes, followed by cleaning with flowing water and drying.

The sheet resistance of the surface on the side on which the composition for forming an n-type diffusion layer was applied was 51 Ω/□. On the surface of the n-type diffusion layer, P (phosphorus) was diffused and an n-type diffusion layer was formed. The sheet resistance of the back surface, however, was 60 Ω/□, and an n-type diffusion layer was formed also on the back surface.

### [Comparative Example 2]

One gram of ammonium dihydrogen phosphate (NH₄H₂PO₄) powder, 7 g of pure water, 0.7 g of polyvinyl alcohol, and 1.5 g of isopropyl alcohol were mixed using an automatic mortar kneading machine to prepare a solution, thereby preparing a composition for an n-type diffusion layer.

Next, on a surface of a p-type silicon substrate, the prepared solution was applied using a spin coater (2000 rpm, 30 sec), and dried at 150°C for 5 minutes on a hot plate, thereby forming a layer. Subsequently, the layer was subjected to a heat treatment in an electric furnace whose temperature was set to 500°C for 5 minutes, and then subjected to a thermal diffusion treatment in another electric furnace for diffusion whose temperature was set to 950°C for 10 minutes. After that, in order to remove a glass layer, the substrate was dipped in hydrofluoric acid for 5 minutes, followed by cleaning with flowing water and drying.

The sheet resistance of the surface on the side on which the composition for forming an n-type diffusion layer was applied was 43 Ω/□. On the surface of the n-type diffusion layer, P (phosphorus) was diffused and an n-type diffusion layer was formed. The sheet resistance of the back surface, however, was 55 Ω/□, and an-type diffusion layer was formed also on the back surface.

The disclosure of Japanese Patent Application No. 2011-158489 filed on July 19, 2011 is incorporated herein by reference in its entirety.

All literatures, patent applications, and technical standards described herein are herein incorporated by reference to the same extent as if each individual literature, patent application, or technical standard was specifically and individually indicated as being incorporated by reference.

## Claims

1. A composition for forming an n-type diffusion layer, the composition comprising:
a glass powder comprising P₂O₅, SiO₂ and CaO; and
a dispersion medium.

2. The composition for forming an n-type diffusion layer according to claim 1, wherein the glass powder comprises P₂O₅ in an amount of from 20 mol% to 50 mol%, SiO₂ in an amount of from 30 mol% to 70 mol%, and CaO in an amount of from 2 mol% to 30 mol%.

3. The composition for forming an n-type diffusion layer according to claim 1 or 2, wherein the glass powder has a volume average particle diameter of 10 µm or less.

4. The composition for forming an n-type diffusion layer according to any one of claims 1 to 3, wherein the glass powder is present in an amount of from 1% by mass to 30% by mass with respect to a total mass.

5. The composition for forming an n-type diffusion layer according to any one of claims 1 to 4, having a viscosity of from 1 Pa·s to 500 Pa·s.

6. The composition for forming an n-type diffusion layer according to any one of claims 1 to 5, wherein the dispersion medium comprises at least one selected from terpineol or butyl carbitol acetate.

7. The composition for forming an n-type diffusion layer according to any one of claims 1 to 6, wherein the dispersion medium comprises ethyl cellulose.

8. A method of producing an n-type diffusion layer, the method comprising the processes of:
applying the composition for forming an n-type diffusion layer according to any one of claims 1 to 7 onto a semiconductor substrate; and
subjecting the semiconductor substrate, on which the composition for forming an n-type diffusion layer has been applied, to a thermal diffusion treatment to form an n-type diffusion layer.

9. The method of producing an n-type diffusion layer according to claim 8, wherein a temperature of the thermal diffusion treatment is from 800°C to 1000°C.

10. The method of producing an n-type diffusion layer according to claim 8 or 9, further comprising, prior to the thermal diffusion treatment, heat treating the semiconductor substrate, on which the composition for forming an n-type diffusion layer has been applied, at a temperature of from 80°C to 300°C to remove at least a part of the dispersion medium comprised in the composition for forming an n-type diffusion layer.

11. The method of producing an n-type diffusion layer according to any one of claims 8 to 10, further comprising, prior to the thermal diffusion treatment, heat treating the semiconductor substrate, on which the composition for forming an n-type diffusion layer has been applied, at a temperature from higher than 300°C to 800°C to remove at least a part of the dispersion medium comprised in the composition for forming an n-type diffusion layer.

12. The method of producing an n-type diffusion layer according to any one of claims 8 to 11, further comprising, after the thermal diffusion treatment, etching a surface of the n-type diffusion layer formed on the semiconductor substrate using hydrofluoric acid.

13. A method of producing a photovoltaic cell element, the method comprising the processes of:
applying the composition for forming an n-type diffusion layer according to any one of claims 1 to 7 onto a semiconductor substrate;
subjecting the semiconductor substrate, on which the composition for forming an n-type diffusion layer has been applied, to a thermal diffusion treatment to form an n-type diffusion layer; and
forming an electrode on the formed n-type diffusion layer.
